# EUROPEAN PATENT APPLICATION

(11) **EP 3 285 008 A1**
(43) Date of publication of application: **21.02.2018**
(21) Application number: 16184719.9
(22) Date of filing: 18.08.2016
(51) Int. Cl.: F24C 7/08, D06F 39/00, G06F 3/0489, H03K 17/96, H05B 6/68

(54) **USER INTERFACE FOR A DOMESTIC APPLIANCE**

(71) Applicant: Electrolux Appliances Aktiebolag, 105 45 Stockholm (SE)
(72) Inventor: BRASSEUR, Jérôme, 105 45 Stockholm (SE); FESER, Jürgen, 91541 Rothenburg ob der Tauber (DE)
(74) Representative: Electrolux Group Patents

(57) **Abstract**

The present invention relates to a user interface (10) for a domestic appliance, in particular for a cooking oven. The user interface (10) comprises at least one input range (12) and at least one display range (14). The input range (12) includes at least one control element (16) formed as a rotary knob as well as a pressure button. The user interface (10) comprises at least one proximity sensor for detecting the presence of the user's hand close to the control element (16). The display range (14) includes at least one numeric display (22) for indicating a current value and at least one further display (22, 24, 32, 34) for indicating information relating to the domestic appliance. The display range (14) includes at least one marking element (30), preferably a cursor (30), for selecting one of the displays (22, 24, 32, 34) on the display range (14). A quick-set mode of the user interface (10) is activated or activatable, after the proximity sensor has detected the presence of the user's hand. During the quick-set mode a display (22, 24, 32, 34) of the display range (14) is selected or selectable by rotating the control element (16).

## Description

The present invention relates to a user interface for a domestic appliance, in particular for a cooking oven. Further, the present invention relates to a domestic appliance, in particular a cooking oven.

A domestic appliance, like a cooking oven, a washing machine or they like, has a lot of different features and functions. Thus, a display of a user interface for such domestic appliance indicates a lot of information. Said information relates to the status of the domestic appliance and the progress of a working process of said domestic appliance.

However, the user does not need all information at all times. It would be advantageous, if the display provides suitable combinations of information being relevant during a current phase or state.

It is an object of the present invention to provide a user interface for a domestic appliance, which allows an easy handling by the user and provides clear representations of information in different situations.

The object is achieved by a user interface according to claim 1.

According to the present invention a user interface for a domestic appliance, in particular for a cooking oven is provided, wherein:
- the user interface comprises at least one input range and at least one display range,
- the input range includes at least one control element formed as a rotary knob as well as a pressure button,
- the user interface comprises at least one proximity sensor for detecting the presence of the user's hand close to the control element,
- the display range includes at least one numeric display for indicating a current value,
- the display range includes at least one further display for indicating information relating to the domestic appliance,
- the display range includes at least one marking element, preferably a cursor, for selecting one of the displays on the display range,
- a quick-set mode of the user interface is activated or activatable, after the proximity sensor has detected the presence of the user's hand,
- during the quick-set mode a display of the display range is selected or selectable by rotating the control element.

According to preferred embodiments of the user interface of the present invention:
- a setting mode of the user interface is activated or activatable by pressing the control element when the numeric display is selected in the quick-set mode, wherein
- during the setting mode the current value is adjusted or adjustable by rotating the control element,
preferably wherein
- an idle mode of the user interface is activated or activatable, after the control element has been released from the user's hand, and
- during the idle mode the numeric display indicates the current value.

The main idea of the present invention is the control element formed as rotary knob and as pressure button in combination with the proximity sensor. In preferred embodiments, the at least three different modes of the user interface can be activated and deactivated by the control element and proximity sensor on the other hand, wherein said modes of the user interface indicate different combinations of displays on the display range. The control element formed as rotary knob and as pressure button and the proximity sensor allows an easy handling. The different modes of the user interface allow clear representations of information on the display range.

Preferably, the proximity sensor is arranged inside the control element. This is a suitable position for detecting the presence of the user's hand in a reliable way.

In particular, the control element is pressed along its rotation axis.

Further, the idle mode of the user interface may be activated or activatable between one second and five seconds, preferably three seconds, after the control element has been released from the user's hand.

Moreover, the input range may include an on-off switch for activating and deactivating the domestic appliance, wherein preferably the on-off switch is a touch key.

At least one of the further displays may be a symbolic display for indicating an operation mode of the domestic appliance and/or a text display for indicating further information relating to the domestic appliance.

Preferably, a start mode is activated or activatable, after the domestic appliance has been activated during a stand-by mode of said domestic appliance, wherein preferably the start mode is activated or activatable by the on-off switch.

A menu mode may be activated or activatable by pressing the control element when a corresponding display is selected in the quick-set mode.

Further, the display range may include at least one first bar for indicating the current value by the length or design of said first bar, and a second bar for indicating a range of said the current value, wherein the first bar and the second bar are arranged side-by-side and parallel to each other, and wherein preferably the second bar includes a marker corresponding with a preset value of the current value.

For example, the first bar and the second bar are curved bars, wherein preferably the first curved bar and the curved second bar enclose partially the control element.

Furthermore, the first bar and the second bar are represented by different colours, wherein preferably the first bar is represented by a signal colour. In particular, the first bar is red.

For example, the cursor is formed as a horizontal bar underlining the selected display, wherein preferably said horizontal bar is represented by a signal colour. Advantageously, the cursor is formed as a red bar.

Moreover, during the idle mode the symbolic display may indicate the current operation mode of the domestic appliance and/or the time display may indicate the real time.

In particular, the numeric display is provided for indicating a current temperature value, wherein preferably said current temperature value is adjusted or adjustable by rotating the control element during the setting mode.

Further, the present invention relates to a domestic appliance, in particular a cooking oven, wherein the domestic appliance comprises at least one user interface mentioned above.

Novel and inventive features of the present invention are set forth in the appended claims.

The present invention will be described in further detail with reference to the drawings, in which
- FIG 1: illustrates a schematic front view of a user interface or a part of said user interface in a stand-by mode according to a preferred embodiment of the present invention,
- FIG 2: illustrates a schematic front view of the user interface or the part of said user interface in a start mode according to the preferred embodiment of the present invention,
- FIG 3: illustrates a schematic front view of the user interface or the part of said user interface in a quick-set mode according to the preferred embodiment of the present invention,
- FIG 4: illustrates a schematic front view of the user interface or the part of said user interface in the quick-set mode according to the preferred embodiment of the present invention,
- FIG 5: illustrates a schematic front view of the user interface or the part of said user interface in a temperature setting mode according to the preferred embodiment of the present invention,
- FIG 6: illustrates a schematic front view of the user interface or the part of said user interface in the temperature setting mode according to the preferred embodiment of the present invention,
- FIG 7: illustrates a schematic front view of the user interface or the part of said user interface in the quick-set mode again according to the preferred embodiment of the present invention,
- FIG 8: illustrates a schematic front view of the user interface or the part of said user interface in an idle mode again according to the preferred embodiment of the present invention, and
- FIG 9: illustrates a schematic front view of the user interface or the part of said user interface in a menu mode according to the preferred embodiment of the present invention.

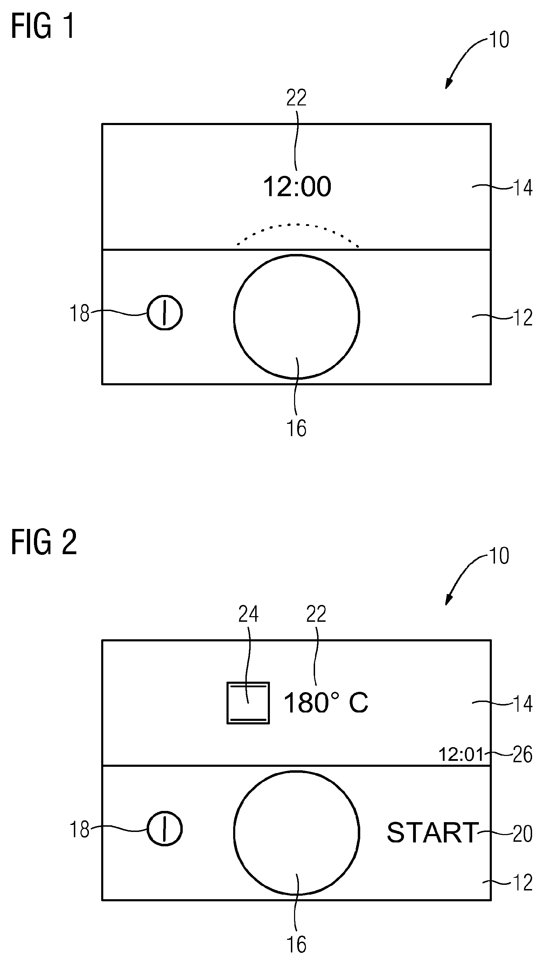

FIG 1 illustrates a schematic front view of a user interface 10 or a part of said user interface 10 in a stand-by mode according to a preferred embodiment of the present invention. In this example, the user interface 10 is provided for a cooking oven. In general, the user interface 10 may be provided for an arbitrary domestic appliance.

The user interface 10 comprises an input range 12 and a display range 14. In this example, the input range 12 and the display range 14 are formed as separate portions of the user interface 10. Alternatively, the input range 12 and the display range 14 may partially or completely overlap, wherein for instance the user interface 10 may be formed as a touch screen.

The input range 12 of the user interface 10 includes a control element 16 and an on-off switch 18. The control element 16 is a rotary knob and a press button rolled into one. The control element 16 is rotatable on the one hand and may be pressed along its rotary axis on the other hand. Further, the input range 12 of the user interface 10 includes a proximity sensor. Preferably, the proximity sensor is arranged inside the control element 16. In general, the proximity sensor may be arranged in an arbitrary positon of the user interface 10, which is suitable to recognise the presence of the user's hand near said user interface 10. The proximity sensor may be an infrared, capacitive, acoustic or any other suitable sensor.

The on-off switch 18 is provided for activating and deactivating the cooking oven. In this example, the on-off switch 18 is a touch key. The display range 14 of the user interface 10 includes a numeric display 22. In the stand-by mode of the user interface 10 the numeric display 22 of the display range 14 indicates the real time.

FIG 2 illustrates a schematic front view of the user interface 10 or the part of said user interface 10 in a start mode according to the preferred embodiment of the present invention. Said start mode is activated, after the on-off switch 18 has been touched by the user.

In the start mode the display range 14 of the user interface 10 indicates the numeric display 22, a symbolic display 24 and a time display 26. The numeric display 22 indicates a preset temperature value. In this example, the pre-set temperature value is 180°C. The symbolic display 24 represents a preset operation mode of the cooking oven. The time display 26 indicates the real time.

In the start mode a start switch 20 is indicated in the input range 14 of the user interface 10. In the start mode the start switch 20 is responsive. The start switch 20 is provided for starting a cooking process. In this example, the on start switch 20 is a touch key.

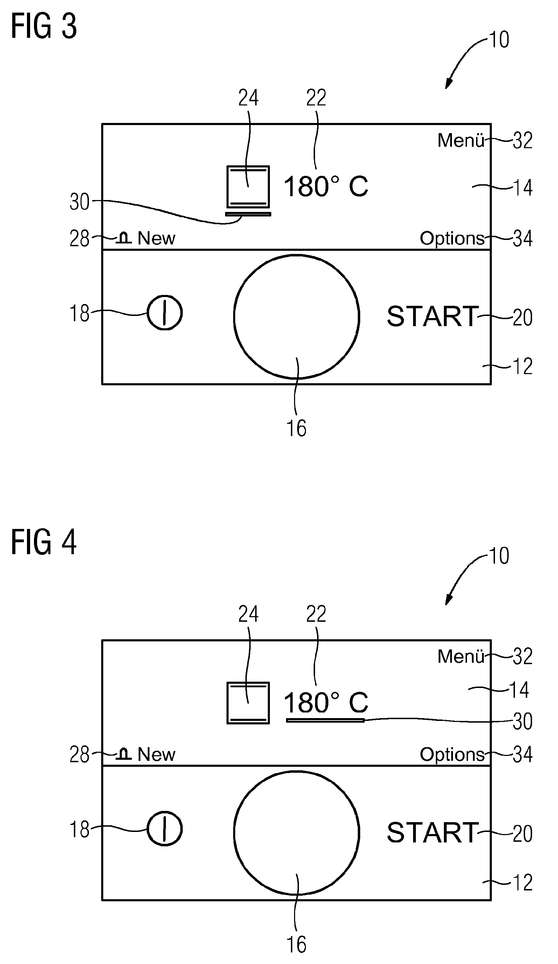

FIG 3 illustrates a schematic front view of the user interface 10 or the part of said user interface 10 in a quick-set mode according to the preferred embodiment of the present invention.

Said quick-set mode is activated, after the control element 16 has been touched by the user and the presence of the user's hand has been detected by the proximity sensor. In particular, the proximity sensor detects the presence of the user's hand, if it touches the control element 16.

In the quick-set mode the display range 14 of the user interface 10 indicates the numeric display 22, the symbolic display 24, a clock symbol 28, a cursor 30 and two text displays 32 and 34. In this example, the cursor 30 is formed as a horizontal bar. In FIG 3 the cursor 30 underlines the symbolic display 24. Preferably, the cursor 30 is represented by a signal colour, for example in red.

A first text display 32 indicates the term "Menu", while a second text display 34 indicates the term "Options". The numeric display 22 still indicates the preset temperature value of 180°C. The start switch 20 is further indicated in the input range 14 during the quick-set mode.

In the quick-set mode the cursor 30 is moveable from item to item within the display range 14 by rotating the control element 16.

FIG 4 illustrates a schematic front view of the user interface 10 or the part of said user interface 10 in the quick-set mode according to the preferred embodiment of the present invention. In FIG 4 the cursor 30 underlines the numeric display 22 indicating the preset temperature value of 180°C. The cursor 30 has been moved from the symbolic display 24, as shown in FIG 3, to the numeric display 22, as shown in FIG 4, by rotating the control element 16.

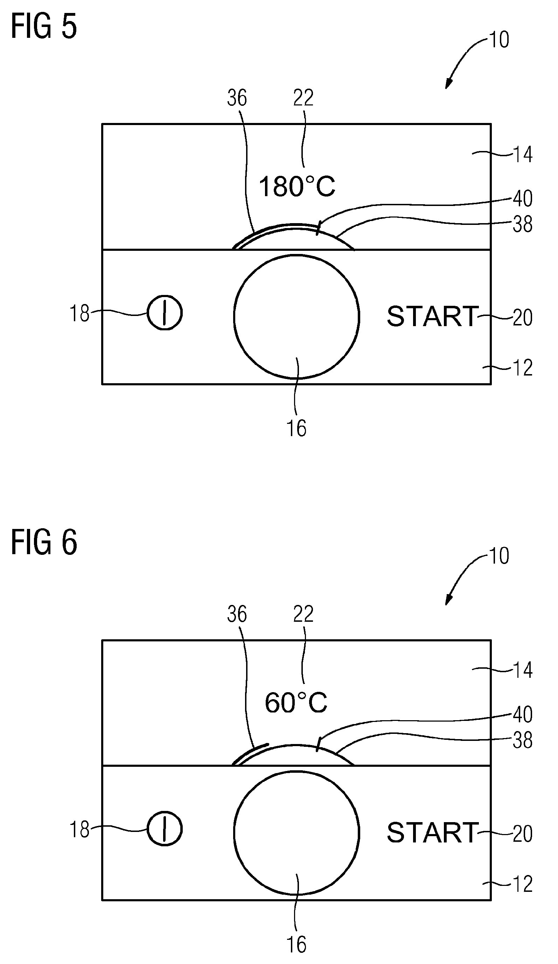

FIG 5 illustrates a schematic front view of the user interface 10 or the part of said user interface 10 in a temperature setting mode according to the preferred embodiment of the present invention. In said temperature setting mode a temperature screen is activated on the display range 14. The temperature setting mode is activated by pressing the control element 16, when the numeric display is marked by the cursor 30, wherein said control element 16 is used like a press button.

In the temperature setting mode the numeric display 22, a first curved bar 36, a second curved bar 38 and a marker 40 are indicated within the display range 14. The first curved bar 36 and the second curved bar 38 are arranged side-by-side and parallel to each other. In this example, the first curved bar 36 and the second curved bar 38 enclose partially the control element 16. The marker 40 indicated a position on the second curved bar 38. Preferably, the first curved bar 36 is represented by a signal colour, for example in red.

The currently set temperature value is indicated by the numeric display 22 and additionally by the first curved bar 36, wherein the length of the first curved bar 36 corresponds with said currently set temperature value. In this example, the numeric display 22 and the first curved bar 36 indicate the temperature value of 180°C.

The currently set temperature value is adjustable by rotating the control element 16. The length of the first curved bar 36 is changed by rotating the control element 16. In the temperature setting mode the user may release and grab again the control element 16. This allows a comfortable adjusting of the currently set temperature value.

FIG 6 illustrates a schematic front view of the user interface 10 or the part of said user interface 10 in the temperature setting mode according to the preferred embodiment of the present invention.

In FIG 6 the currently set temperature value is adjusted by rotating the control element 16. The currently set temperature value is indicated by the numeric display 22 and the first curved bar 36. In this example, the numeric display 22 and the first curved bar 36 indicate the set temperature value of 60°C. If the set temperature value is confirmed by pressing the control element 16, then the user interface 10 returns into the quick-set mode.

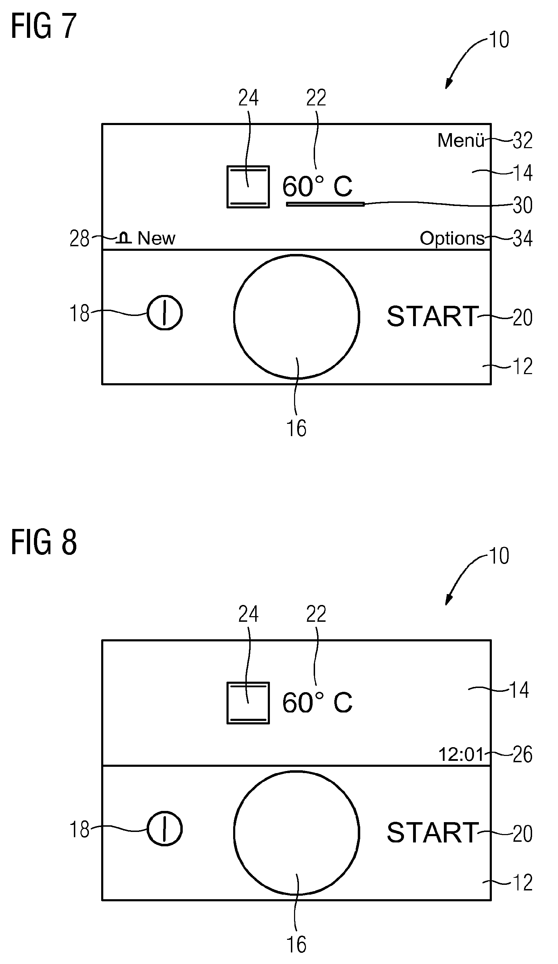

FIG 7 illustrates a schematic front view of the user interface 10 or the part of said user interface 10 in the quick-set mode again according to the preferred embodiment of the present invention. Said quick-set mode has been activated again, after the set temperature value of 60°C has been confirmed by pressing the control element 16 as shown in FIG 6.

In the quick-set mode the display range 14 of the user interface 10 indicates the numeric display 22, the symbolic display 24, the clock symbol 28, the cursor 30 and both text displays 32 and 34. The numeric display 22 indicates the set temperature value of 60°C. The cursor 30 underlines the numeric display 22.

FIG 8 illustrates a schematic front view of the user interface 10 or the part of said user interface 10 in an idle mode according to the preferred embodiment of the present invention.

Said idle mode is activated, after the user has been released the control element 16 in the quick-set mode shown in FIG 7. Preferably, the activation of the idle mode takes a few seconds, for example, between one and five seconds, in particular three seconds, after the user has been released the control element 16 in the quick-set mode.

In the idle mode the numeric display 22, the symbolic display 24 and the time display 26 are indicated. Thus, only the most important features within the display range 14 are indicated in the idle mode. The numeric display 22 indicates the set temperature value. The symbolic display 24 represents the current cooking mode of the cooking oven. The time display 26 indicates the real time. However, the text display 32 "Menu" and the text display 34 "Options" are not visible in the idle mode.

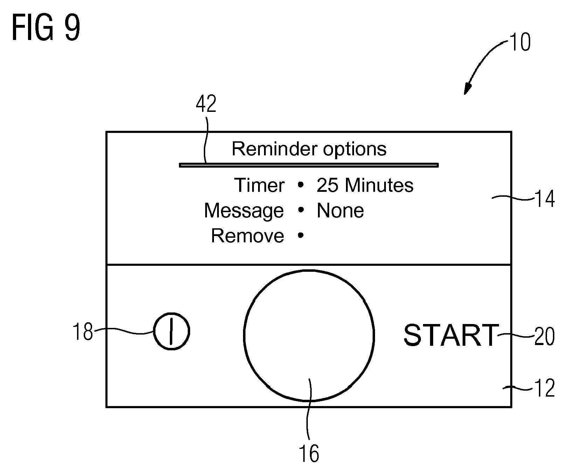

FIG 9 illustrates a schematic front view of the user interface 10 or the part of said user interface 10 in a menu mode according to the preferred embodiment of the present invention.

Said menu mode is activated, after the user has chosen "Menu" in the first text display 32 or "Options" in the second text display 34 by setting the cursor 30 beneath said text display 32 or 34, respectively, and pressing the control element 16 in the quick-set mode shown in FIG 3, FIG 4 and FIG 7. The menu mode may be deactivated by pressing the control element 16 again.

The user interface according to the present invention is provided for an arbitrary domestic appliance, like a cooking oven, a microwave oven, a cooking hob, a dishwasher, a washing machine, a laundry dryer and a washer dryer.

Although an illustrative embodiment of the present invention has been described herein with reference to the accompanying drawings, it is to be understood that the present invention is not limited to that precise embodiment, and that various other changes and modifications may be affected therein by one skilled in the art without departing from the scope or spirit of the invention. All such changes and modifications are intended to be included within the scope of the invention as defined by the appended claims.

### List of reference numerals

- 10: user interface
- 12: input range
- 14: display range
- 16: control element
- 18: on-off switch
- 20: start switch
- 22: numeric display
- 24: symbolic display
- 26: time display
- 28: clock symbol
- 30: cursor
- 32: first text display
- 34: second text display
- 36: first curved bar
- 38: second curved bar
- 40: marker
- 42: table

## Claims

1. A user interface (10) for a domestic appliance, in particular for a cooking oven, wherein:
- the user interface (10) comprises at least one input range (12) and at least one display range (14),
- the input range (12) includes at least one control element (16) formed as a rotary knob as well as a pressure button,
- the user interface (10) comprises at least one proximity sensor for detecting the presence of the user's hand close to the control element (16),
- the display range (14) includes at least one numeric display (22) for indicating a current value,
- the display range (14) includes at least one further display (22, 24, 32, 34) for indicating information relating to the domestic appliance,
- the display range (14) includes at least one marking element (30), preferably a cursor (30), for selecting one of the displays (22, 24, 32, 34) on the display range (14),
- a quick-set mode of the user interface (10) is activated or activatable, after the proximity sensor has detected the presence of the user's hand,
- during the quick-set mode a display (22, 24, 32, 34) of the display range (14) is selected or selectable by rotating the control element (16).

2. The user interface according to claim 1,
**characterized in that**
- a setting mode of the user interface (10) is activated or activatable by pressing the control element (16) when the numeric display (22) is selected in the quick-set mode, and
- during the setting mode the current value is adjusted or adjustable by rotating the control element (16).

3. The user interface according to claim 2,
**characterized in that**
- an idle mode of the user interface (10) is activated or activatable, after the control element 16 has been released from the user's hand, and
- during the idle mode the numeric display (22) indicates the current value.

4. The user interface according to any of the preceding claims,
**characterised in that**
the proximity sensor is arranged inside the control element (16), and or
the control element (16) is pressed along its rotation axis.

5. The user interface according to any one of the preceding claims,
**characterised in that**
the idle mode of the user interface (10) is activated or activatable between one second and five seconds, preferably three seconds, after the control element (16) has been released from the user's hand.

6. The user interface according to any one of the preceding claims,
**characterised in that**
the input range (12) includes an on-off switch (18) for activating and deactivating the domestic appliance, wherein preferably the on-off switch (18) is a touch key.

7. The user interface according to any one of the preceding claims,
**characterised in that**
at least one of the further displays is a symbolic display (24) for indicating an operation mode of the domestic appliance and/or a text display (32, 34) for indicating further information relating to the domestic appliance.

8. The user interface according to any one of the preceding claims,
**characterised in that**
a start mode is activated or activatable, after the domestic appliance has been activated during a stand-by mode of said domestic appliance, wherein preferably the start mode is activated or activatable by the on-off switch (18).

9. The user interface according to any one of the preceding claims,
**characterised in that**
a menu mode is activated or activatable by pressing the control element (16) when a corresponding display (32) is selected in the quick-set mode.

10. The user interface according to any one of the preceding claims,
**characterised in that**
the display range (14) includes at least one first bar (36) for indicating the current value by the length or design of said first bar (36), and a second bar (38) for indicating a range of said the current value, wherein the first bar (36) and the second bar (38) are arranged side-by-side and parallel to each other, and wherein preferably the second bar (38) includes a marker (40) corresponding with a preset value of the current value.

11. The user interface according to any one of the preceding claims,
**characterised in that**
the first bar (36) and the second bar (38) are curved bars (36, 38), wherein preferably the first curved bar (36) and the curved second bar (38) enclose partially the control element (16).

12. The user interface according to claim 10 or 11,
**characterised in that**
the first bar (36) and the second bar (38) are represented by different colours, wherein preferably the first bar (36) is represented by a signal colour.

13. The user interface according to any one of the preceding claims,
**characterised in that**
the cursor (30) is formed as a horizontal bar underlining the selected display (22, 24, 32, 34), wherein preferably said bar is represented by a signal colour.

14. The user interface according to any one of the preceding claims,
**characterised in that**
during the idle mode the symbolic display (24) indicates the current operation mode of the domestic appliance and/or the time display (26) indicates the real time.

15. The user interface according to any one of the preceding claims,
**characterised in that**
the numeric display (22) is provided for indicating a current temperature value, wherein preferably said current temperature value is adjusted or adjustable by rotating the control element (16) during the setting mode.

16. A domestic appliance, in particular a cooking oven,
**characterised in that**
the domestic appliance comprises at least one user interface (10) according to any one of the claims 1 to 15.
